# EUROPÄISCHE PATENTSCHRIFT

(11) **EP 1 741 130 B1**
(45) Veröffentlichungstag und Bekanntmachung des Hinweises auf die Patenterteilung: **03.11.2010**
(21) Anmeldenummer: 05735966.3
(22) Anmeldetag: 19.04.2005
(51) Int. Cl.: H01L 21/68, H01L 21/00, G03F 7/16

(54) **VORRICHTUNG UND VERFAHREN FÜR DIE BEARBEITUNG EINES SUBSTRATS IN DER HALBLEITERTECHNIK SOWIE SYSTEM, DAS EINE VORRICHTUNG FÜR DIE BEARBEITUNG EINES SUBSTRATS UMFASST**
DEVICE AND METHOD FOR TREATING A SUBSTRATE IN THE FIELD OF SEMICONDUCTOR TECHNOLOGY, IN ADDITION TO A SYSTEM COMPRISING A DEVICE FOR TREATING A SUBSTRATE
DISPOSITIF ET PROCEDE DE TRAITEMENT D'UN SUBSTRAT SELON LA TECHNOLOGIE DES SEMICONDUCTEURS ET SYSTEME COMPORTANT UN DISPOSITIF DE TRAITEMENT D'UN SUBSTRAT

(30) Priorität: 20.04.2004 DE 102004019732
(43) Veröffentlichungstag der Anmeldung: 10.01.2007
(73) Patentinhaber: SSE Sister Semiconductor Equipment GmbH, 78224 Singen (DE)
(72) Erfinder: HOFFMANN, Dirk, 78354 Sipplingen (DE)
(74) Vertreter: Dobler, Markus
(86) Internationale Anmeldenummer: PCT/DE2005/000713
(87) Internationale Veröffentlichungsnummer: WO 2005/104219

(56) Entgegenhaltungen:
- EP-A- 0 634 699
- WO-A-01/22477
- WO-A-99/02752

## Beschreibung

Die Erfindung betrifft eine Vorrichtung und ein Verfahren zur Bearbeitung eines Substrates in der Halbleitertechnik nach dem Oberbegriff des Anspruchs 1 bzw. 6 sowie ein System, das eine Vorrichtung für die Bearbeitung eines Substrats umfasst.

### Stand der Technik:

In der Halbleitertechnik spielen Prozesszeiten für die Bearbeitung von Substraten, z.B. Wafern oder Glasplatten bei der Herstellung von beispielsweise Flüssigkristallbildschirmen vor dem Hintergrund des zunehmenden Preisdrucks eine bedeutende Rolle.

Dementsprechend sind in modernen Halbleiterfabrikationen ein Großteil der Prozesse insbesondere unter Einsatz von Handhabungsrobotern automatisiert um rationell fertigen zu können.

Für eine Beschichtung von Substraten mit einem flüssigen Medium, wie beispielsweise Fotolack, wird in einem automatisierten Ablauf ein zu beschichtendes Substrat in einer Ausführungsform von einem Einzelsubstrat-Handhabungsroboter (single handling roboter) aufgenommen und in einem Prozesstopf zum Spinbelacken des Substrats verbracht. Nach der Fertigprozessierung wird das Substrat vom Einzelsubstrat-Handhabungsroboter wieder aufgenommen und in eine Trocknungseinheit transportiert, in welcher das aufgebrachte flüssige Medium für eine Weiterprozessierung getrocknet wird.

Bei diesem Vorgang sind Prozesszykluszeiten für einen reproduzierbaren Prozessablauf wichtige Prozessparameter, die eingehalten werden sollten.

Beispielhaft für eine Bearbeitungsvorrichtung des Standes der Technik offenbart die Europäische Patentanmeldung EP 0 634 699 A1 eine Vorrichtung gemäß der Präambel von Anspruch 1 der vorliegenden Anmeldung, ohne einen Hilfshandhabungsroboter in der Pufferstation aufzuweisen oder nahezulegen.

### Aufgabe und Vorteile der Erfindung:

Der Erfindung liegt die Aufgabe zugrunde, den Prozessablauf für die Bearbeitung eines Substrats, das während des Prozesses mit einem Handhabungssystem befördert wird, weiter zu optimieren.

Diese Aufgabe wird durch die Merkmale des Anspruchs 1, 5 bzw. 6 gelöst.

In den Unteransprüchen sind vorteilhafte und zweckmäßige Ausgestaltungen der Erfindung angegeben.

Die Erfindung geht zunächst von einer Vorrichtung für die Bearbeitung eines Substrats in der Halbleitertechnik, insbesondere eines Wafers oder einer Glasplatte aus, die eine Prozessstation, in welcher eine Substratprozessierung stattfindet sowie ein Einzelsubstrat-Handhabungsroboter für den Transport eines einzelnen Substrats von einer Eingangsstation in die Prozessstation und zu einer Ausgangsstation umfasst.

Der wesentliche Aspekt der Erfindung liegt nun darin, dass eine Pufferstation vorgesehen ist, die einen Hilfshandhabungsroboter zum Transport eines Substrates von der Prozessstation in die Pufferstation umfasst, und dass der Einzelsubstrat-Handhabungsroboter dazu ausgelegt ist, ein Substrat von der Eingangsstation in die Prozessstation und von der Pufferstation in die Ausgangsstation zu befördern. Durch diese Ausgestaltungsmaßnahmen wird es möglich, die Durchlaufzeiten durch die Prozessstation zu erhöhen. Denn nachdem ein fertig prozessiertes Substrat in der Pufferstation liegt, kann die Prozessstation mit dem Einzelsubstrat-Handhabungsroboter schon wieder mit einem neuen Substrat beladen werden, das dann während der Einzelsubstrat-Handhabungsroboter das zuvor prozessierte Substrat in die Ausgangsstation bringt, in der Prozessstation bearbeitet werden kann. Nach Ablegen des Substrats in der Ausgangsstation kann der Einzelsubstrat-Handhabungsroboter sofort wieder ein neues Substrat für das Verbringen in die Prozessstation aufnehmen und nachdem der Hilfshandhabungsroboter die Prozessstation frei gemacht hat, ein neues Substrat darin ablegen, dass dann in einem neuen Zyklus entsprechend prozessiert wird, während ein Verbringen des zuvor bearbeiteten Substrats mittels des Einzelsubstrats-Handhabungsroboter in die Ausgangsstation erfolgt.

Durch dieses Parallelisieren von einzelnen Prozessschritten ist eine nicht unerhebliche Zeitersparnis im Prozessablauf möglich, wobei nach wie vor nur ein Einzelsubstrat-Handhabungsroboter erforderlich ist, der Substrate von der Eingangsstation in die Ausgangsstation befördern kann. Der Hilfshandhabungsroboter muss lediglich ein Substrathandling zwischen Prozessstation und Pufferstation ausführen können, womit dieser im Vergleich zum Einzelsubstrat-Handhabungsroboter deutlich einfacher ausgeführt werden kann. Damit ist die erfindungsgemäße Vorrichtung mit der damit gewonnenen Zeitersparnis durch Parallelisierung auch im Hinblick auf die erforderlichen Investitionen attraktiv.

Die erfindungsgemäßen Vorteile ergeben sich insbesondere, wenn es sich bei der Vorrichtung um eine Spin-Belackungsanordnung handelt. In diesem Fall ist die Prozessstation vorzugsweise in Form einer Spin-Belackungseinheit ausgebildet. Ein Komplettsystem umfasst vorzugsweise die soeben erläuterte Vorrichtung sowie eine Eingangsstation und eine Ausgangsstation, die insbesondere als Trocknungseinheit ausgebildet ist.

Trotz Einsatz eines Single-Handling-Roboters für den Substrattransport von der Eingangsstation in eine Ausgangsstation (Trocknungseinheit) lassen sich in diesem Fall die Prozesszeiten um 10 bis 40 % herabsetzen.

Ein weiterer Vorteil der erfindungsgemäßen Vorgehensweise liegt darin, dass der erforderliche zusätzliche Raumbedarf für die Pufferstation mit Hilfshandhabungsrobotern kaum ins Gewicht fällt.

Bei einem Verfahren zur Bearbeitung eines Substrats, bei welchem das Substrat mittels eines Einzelhandhabungsroboters von einer Eingangsstation in eine Prozessstation und nach der Prozessierung in der Prozessstation in eine Ausgangsstation transportiert wird, liegt der Kerngedanke darin, dass nach der Prozessierung des Substrats in der Prozesseinheit das prozessierte Substrat in eine Pufferstation gebracht wird, dass mittels des Einzelsubstrat-Handhabungsroboters die Prozesseinheit mit einem neuen Substrat beladen wird und dass daran anschließend mit dem Einzelsubstrat-Handhabungsroboter das prozessierte Substrat aus der Pufferstation in die Ausgangsstation transportiert-wird. Während des Transports eines Substrats in die Ausgangsstation durch den Einzelsubstrat-Handhabungsroboter kann die Prozessstation den Prozess an einem neuen Substrat ausführen. Gegebenenfalls kann noch während des Prozessierungsvorgangs ein neues Substrat vom Einzelsubstrat-Handhabungsroboter aufgenommen werden, so dass dieses unmittelbar nachdem das Verbringen eines prozessierten Substrats in die Pufferstation erfolgt ist, in der Prozessstation abgelegt werden kann. Der Transport des Substrats aus der Prozessstation in die Pufferstation erfolgt vorzugsweise mit einem Hilfshandhabungsroboter. Dieser kann, wie bereits oben ausgeführt, im Vergleich zu dem Einzelsubstrat-Handhabungsroboter, der Substrate von der Eingangsstation in die Ausgangsstation befördern können muss, deutlich einfacher und damit kostengünstiger und platzsparender ausgeführt werden.

Der Parallelisierungsgrad hängt von der konkreten geometrischen Anordnung und der Prozesszeit in der Prozessstation ab.

### Beschreibung des Ausführungsbeispiels:

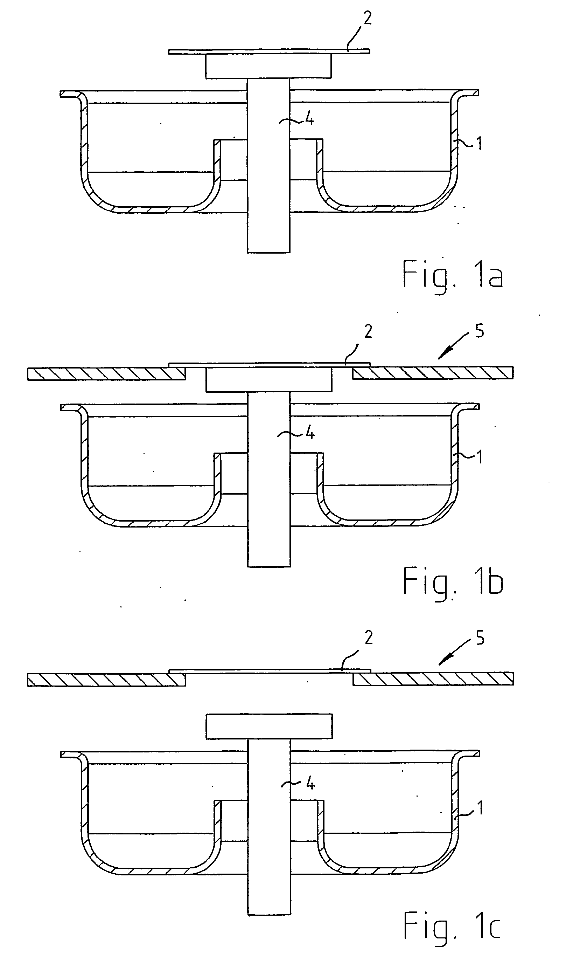

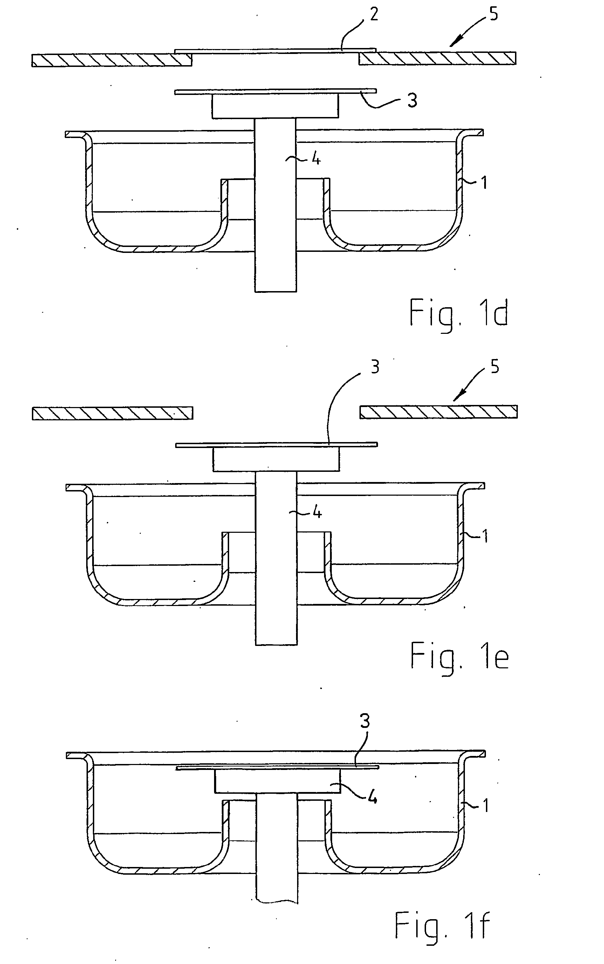

Ein Ausführungsbeispiel der Erfindung ist in den Zeichnungen dargestellt und wird unter Angabe weiterer Einzelheiten und Vorteile nachstehend näher erläuterte Die Figuren 1a bis f zeigen in schematischen Schnittbildern die Prozessierung von Substraten in einer Prozessstation. Eine Eingangs- und Ausgangsstation sowie ein Einzelsubstrat-Handhabungsroboter sind nicht dargestellt.

In den Figuren 1a bis f ist in einem schematischen Schnittbild ein Prozesstopf 1, für das Spinbelacken von Substraten 2, 3 mit flüssigem Medium dargestellt. Dazu ist im Prozesstopf 1 ein rotierbarer Drehteller 4 vorgesehen, auf welchem Substrate 2, 3 abgelegt und während des Beschichtungsvorganges in Rotation versetzt werden können.

Ein Belackungsvorgang läuft folgendermaßen ab:
1. Ein fertig belacktes Substrat 2 wird im vorliegenden Beispiel durch Anheben des Drehtellers 4 aus dem Prozesstopf 1 gehoben (Figur 1a), von einem Hilfshandhabungsroboter 5 einer Pufferstation (nicht weiter dargestellt) aufgenommen (Figur 1b) und in eine Pufferposition gebracht (siehe Figur 1c).
2. Damit ist der noch ausgefahrene Drehteller 4 bereit für das Auflegen eines neuen Substrats mit einem Einzelsubstrat-Handhabungsroboters (nicht dargestellt), was in Figur 1d bereits erfolgt ist. Hier wurde das neue Substrat 3 auf dem Substratteller 4 abgelegt.
   Nach Ablegen des neuen Substrats 3 auf dem Substratteller 4 ist der nicht abgebildete Einzelsubstrat-Handhabungsroboter frei, das bereits prozessierte Substrat 2 aus der Pufferposition aufzunehmen und in eine Ausgangsstation, insbesondere einen Zacktrocknungsofen (nicht dargestellt) zu verbringen.
   In Figur le wurde das prozessierte Substrat 2 aufgenommen und wegbefördert.
   Währenddessen kann nun das neu aufgelegte Substrat 3 im Prozesstopf 1 belackt werden, wobei der Hilfshandhabungsroboter 5 in eine Warteposition gefahren ist (diese Situation ist in Figur 1f dargestellt).
3. Sobald die Prozessierung des Substrats 3 im Prozesstopf 1 abgeschlossen ist, wird es mittels des Drehtellers 4 in eine Abgreifposition für den Hilfshandhabungsroboter 5 gefahren womit ein neuer Zyklus beginnt. Der Hilfshandhabungsroboter wird zum Abgreifen des neuen Substrats aus der Warteposition in die Abgreifposition gebracht (dieser Vorgang ist noch mit dem vorangegangen Substrat 2 in den Figuren 1a und 1b verdeutlicht).

Durch diesen Prozessablauf wird eine Parallelisierung in einer Weise realisiert, dass erst während des Prozessieren eines Substrates (z.B. Substrat 3) ein zuvor prozessiertes Substrat vom einzigen vorhandenen Einzelsubstrat-Handhabungsroboter in eine andere notwendige Position gebracht werden kann, was eine Zeitersparnis in der Größenordnung von 10 bis 40 % im Prozeßablauf möglich macht. Als Voraussetzung hierfür ist als wesentlicher Punkt die Einführung einer Zwischenablage. Zum Erreichen der Zwischenablage werden vorzugsweise einfache konstruktive Mittel eingesetzt, die auch nur dafür vorgesehen sind, ein Substrat aus der Prozessstation von der Aufnahmeposition in die Zwischenablage zu bringen. Um einen Parallelisierungsgrad zu erreichen, sollte der Transport in die Zwischenablage schneller durchführbar sein, als insbesondere ein Transport des Substrats in die Ausgangsstation.

Dies lässt sich insbesondere dadurch erreichen, dass für den Puffervorgang kleinere Wege zurückgelegt werden müssen, verglichen mit dem Transport des Substrats in eine Ausgangsstation und/oder dem Transport eines Substrats von einer Eingangsstation in die Prozessstation.

### Bezugszeichenliste:

- 1: Prozesstopf
- 2: Substrat
- 3: Substrat
- 4: Drehteller
- 5: Hilfshandhabungsroboter

## Patentansprüche

1. Vorrichtung für die Bearbeitung eines Substrats (2, 3) in der Halbleitertechnik, insbesondere eines Wafers oder einer Glasplatte mit einer Prozessstation (1, 4), in welcher eine Substratprozessierung stattfindet sowie einem Einzelsubstrat-Handhabungsroboter für den Transport eines einzelnen Substrates von einer Eingangsstation in die Prozessstation (1, 4) und zu einer.Ausgangsstation, **dadurch gekennzeichnet, dass** eine Pufferstation vorgesehen ist, die einen Hilfshandhabungsroboter (5) zum Transport eines Substrates (2, 3) von der Prozessstation (1, 4) in die Pufferstation umfasst, und dass der Einzelsubstrat-Handhabungsroboter dazu ausgelegt ist, ein Substrat (2, 3) von der Eingangsstation in die Prozessstation und von der Pufferstation in die Ausgangsstation zu befördern.

2. Vorrichtung nach Anspruch 1, **dadurch gekennzeichnet, dass** der Hilfshandhabungsroboter (5) derart ausgelegt ist, dass kein Substrattransport von der Eingangsstation oder zur Ausgangsstation mit dem Hilfshandhabungsroboter (5) möglich ist.

3. Vorrichtung nach einem der vorhergehenden Ansprüche, **dadurch gekennzeichnet, dass** die Vorrichtung eine Spinbelackungsanordnung ist.

4. Vorrichtung nach einem der vorhergehenden Ansprüche, dadur.ch **gekennzeichnet**, dass die Prozessstation in Form einer Spinbelackungseinheit (1, 4) ausgebildet ist.

5. System bestehend aus einer Vorrichtung nach einem der vorhergehenden Ansprüche sowie einer Eingangsstation und einer Ausgangsstation, die insbesondere als Trocknungseinheit ausgebildet ist.

6. Verfahren zur Bearbeitung eines Substrats (2, 3) in der Halbleitertechnik, bei welchem das Substrat (2, 3) mit einem Einzelsubstrat-Handhabungsroboter von einer Eingangsstation in eine Prozessstation (1, 4) und nach der Prozessierung in der Prozessstation (1, 4) in eine Ausgangsstation transportiert wird, **dadurch gekennzeichnet, dass** nach der Prozessierung des Substrats in der Prozessstation (1, 4) das prozessierte Substrat in eine Pufferstation gebracht wird, dass mittels des Einzelsubstrat-Handhabungsroboters die Prozessstation (1, 4) mit einem neuen Substrat (3) beladen wird, und dass daran anschließend mit dein Einzelsubstrat-Handhabungsroboter das zuvor prozessierte Substrat (2) aus der Pufferstation in die Ausgangsstation transportiert wird.

7. Verfahren nach Anspruch 6, **dadurch gekennzeichnet, dass** der Transport des Substrates (2, 3) aus der Prozessstation (1, 4) in die Pufferstation mit einem Hilfshandhabungsroboter (5) erfolgt.

8. Anwendung des Verfahrens nach Anspruch 6 oder 7 für einen Substratbelackungsprozess, bei welchem in der Prozessstation (1, 4) eine Substratbelackung, insbesondere mittels eines Spinbelackers und in der Ausgangsstation eine Lacktrocknung, insbesondere mittels eines Trocknungsofens stattfindet.

## Claims

1. A device for treating a substrate (2, 3) in the field of semiconductor technology, in particular a wafer or glass plate, comprising a process station (4), in which substrate processing takes place, in addition to an individual substrate handling robot for the transport of an individual substrate from an inlet station into the process station (1, 4) and to an outlet station, **characterized in that** a buffer station is provided, which comprises an auxiliary handling robot (5) for transporting a substrate (2, 3) from the process station (1, 4) into the buffer station, and **in that** the individual substrate handling robot is designed to convey a substrate (2, 3) from the inlet station into the process station and from the buffer station into the outlet station.

2. The device as claimed in claim 1, **characterized in that** the auxiliary handling robot (5) is designed in such a way that no substrate transport from the inlet station or to the outlet station by the auxiliary handling robot (5) is possible.

3. The device as claimed in one of the preceding claims, **characterized in that** the device is a spin-coating arrangement.

4. The device as claimed in one of the preceding claims, **characterized in that** the process station is constructed in the form of a spin-coating unit (1, 4).

5. A system comprising the device as claimed one of the preceding claims and, in addition, an inlet station and an outlet station, which in particular is constructed as a drying unit.

6. A method for treating a substrate (2, 3) in the field of semiconductor technology, in which the substrate (2, 3) is transported from an inlet station into a process station (1, 4) by means of an individual handling robot and, after the processing in the process station (1, 4), is transported into an outlet station, **characterized in that**, after the processing of the substrate in the process station (1, 4), the processed substrate is moved into a buffer station, **in that**, by means of the individual substrate handling robot, the process station (1, 4) is loaded with a new substrate (3) and **in that** then, using the individual substrate handling robot, the previously processed substrate (2) is transported from the buffer station into the outlet station.

7. The method as claimed in claim 6, **characterized in that** the transport of the substrate (2, 3) out of the process station (1, 4) into the buffer station is carried out by an auxiliary handling robot (5).

8. The use of the method as claimed in claim 6 or 7 for a substrate coating process, in which substrate coating is carried out in the process station (1, 4), in particular by means of a spin-coater, and coating drying is carried out in the outlet station, in particular by means of a drying oven.

## Revendications

1. Dispositif de traitement d'un substrat (2, 3) en technique des semiconducteurs notamment une puce ou une plaque en verre comprenant un poste de traitement (1, 4) dans lequel s'effectue un traitement du substrat ainsi qu'un robot de manipulation d'un substrat individuel pour transporter ce substrat individuel d'un poste d'entrée dans le poste de traitement (1, 4) et vers un poste de sortie,
dispositif **caractérisé par**
un poste tampon comportant un robot de manipulation auxiliaire (5) pour transporter un substrat (2, 3) d'un poste de traitement (1, 4) dans le poste tampon, et
le robot de manipulation du substrat individuel est conçu pour transférer un substrat (2, 3) du poste d'entrée dans le poste de traitement et du poste tampon dans le poste de sortie.

2. Dispositif selon la revendication 1,
**caractérisé en ce que**
le robot de manipulation auxiliaire (5) est conçu pour qu'il ne permette aucun transport de substrat à partir du poste d'entrée ou vers le poste de sortie.

3. Dispositif selon l'une quelconque des revendications précédentes,
**caractérisé en ce qu'**
il comporte un dispositif de vernissage rotatif.

4. Dispositif selon l'une quelconque des revendications précédentes,
**caractérisé en ce que**
le poste de traitement a la forme d'une unité de vernissage rotatif (1, 4),

5. Système composé d'un dispositif selon l'une des revendications précédentes ainsi que d'un poste d'entrée et d'un poste de sortie réalisés notamment comme unité de séchage.

6. Procédé de traitement d'un substrat (2, 3) en technique des semiconducteurs selon lequel le substrat (2, 3) est transporté par un robot de manutention de substrat individuel, d'un poste d'entrée dans un poste de traitement (1, 4) et après le traitement effectué dans le poste de traitement (1, 4) vers un poste de sortie,
procédé **caractérisé en ce qu'**
- après le traitement du substrat dans le poste de traitement (1, 4), on met le substrat traité dans un poste tampon,
- à l'aide du robot de manipulation de substrat individuel, on charge le poste de traitement (1, 4) avec un nouveau substrat (3), et
- ensuite, avec le robot de manipulation de substrat individuel, on transporte le substrat (2) traité préalablement du poste tampon vers le poste de sortie.

7. Procédé selon la revendication 6,
**caractérisé en ce que**
le transport de substrat (2, 3) à partir du poste de traitement (1, 4) vers le poste tampon se fait à l'aide d'un robot de manutention auxiliaire (5).

8. Application du procédé selon les revendications 6 ou 7 pour un procédé de vernissage de substrat selon lequel dans le poste de traitement (1, 4), on applique un vernis sur le substrat notamment par un dispositif de vernissage rotatif et dans le poste de sortie, on fait un séchage du vernis notamment à l'aide d'un four de séchage.
